# EUROPEAN PATENT APPLICATION

(11) **EP 2 457 968 A1**
(43) Date of publication of application: **30.05.2012**
(21) Application number: 11009367.1
(22) Date of filing: 25.11.2011
(51) Int. Cl.: C09J 7/02

(54) **Surface protective sheet**

(30) Priority: 30.11.2010 JP 2010266030; 11.10.2011 JP 2011223823
(71) Applicant: NITTO DENKO CORPORATION, Ibaraki-shi, Osaka 567-8680 (JP)
(72) Inventor: Sawazaki, Ryohei, Osaka 567-8680 (JP); Hayashi, Keiji, Osaka 567-8680 (JP); Yamato, Jiro, Osaka 567-8680 (JP); Yoshida, Mariko, Osaka 567-8680 (JP); Yamamoto, Mitsushi, Osaka 567-8680 (JP); Yamashita, Kenta, Osaka 567-8680 (JP)
(74) Representative: Müller-Boré & Partner Patentanwälte

(57) **Abstract**

Provided is a surface protective sheet, which satisfactorily adheres to an adherend and which can be easily re-released and suppresses contamination due to a pressure-sensitive adhesive remaining on the surface of the adherend after the release of the sheet. The surface protective sheet includes: a base material layer; and a pressure-sensitive adhesive layer, in which a difference ΔT (%) between the visible light transmittance T₁ (%) of a transparent substrate having an antireflection film and the visible light transmittance T₂ (%) of the transparent substrate resulting when the surface protective sheet is attached to one side of the transparent substrate and left to stand at 160°C for 1 hour, and then the surface protective sheet is released under a temperature environment of 23°C (ΔT=T₁-T₂) satisfies a relationship of ΔT≤1.8.

## Description

The present invention relates to a surface protective sheet. The surface protective sheet of the present invention is used in, for example, an application where the surface of a member such as a metal plate, a coated plate, an aluminum sash, a resin plate, a decorated steel plate, a vinyl chloride-laminated steel plate, or a glass plate, an optical member such as a polarizing sheet or a liquid crystal panel, an electronic member, or the like is protected by attaching the sheet to the surface of any such member during, for example, conveyance, processing, or guarding of the member. The surface protective sheet is particularly useful as a surface protective sheet, whose degree of contamination is requested to be low, for a hydrophilic member obtained by hydrophilizing the surface of a metal plate, a resin plate, a glass plate, or the like with a hydrophilic coating film or a surface treatment, a substrate with an antireflection function formed so as to have a thickness corresponding to a quarter of a wavelength to be prevented from reflecting, a substrate with an antireflection function based on a nano-level uneven structure, or the like.

There exist various coated plates such as a coated steel plate ranging from a plate having a smooth surface to a plate having a rough surface, and the attachment of a surface protective sheet to the surface of any such plate has been generally performed for protecting the surface from, for example, a flaw at the time of its conveyance or processing. The surface protective sheet is typically obtained by providing one side of a base material layer with a pressure-sensitive adhesive layer.

The surface protective sheet is demanded, for example, to be easily released and to cause no contamination due to a pressure-sensitive adhesive remaining on an adherend after the release of the surfaceprotective sheet as well as to have satisfactory pressure-sensitive adhesiveness and a stable adhesion. For example, Japanese Patent Application Laid-open No. 2010-36448 reports a surface protective sheet which reduces contamination due to a pressure-sensitive adhesive.

In recent years, there has been developed a technology that achieves decreased reflection and increased transmission of incident light by using a coating material having dispersed therein fine particles of nanometer size each containing an inorganic substance such as silica as a main component to form a coating film on each of various substrates (for example, International Patent WO2008/041681A1). The coating film has extremely fine unevenness, and hence has a drawback in that the film is liable to be damaged and broken. Therefore, the surface protective sheet is used during conveyance or processing of a substrate having the coating film. However, the use of the surface protective sheet for the above-mentioned substrate having the coating film causes contamination due to a pressure-sensitive adhesive remaining on the substrate after the release of the sheet, resulting in reductions of both the reflectance and transmittance of the substrate, which may impair characteristics imparted by an antireflection film. In addition, in some applications, an assembling process includes a heating step at 150°C or more. When such heating step is performed, even the use of the surface protective sheet disclosed in Japanese Patent Application Laid-open No. 2010-36448 causes contamination due to the remaining of a pressure-sensitive adhesive.

The present invention has been made to solve the above-mentioned conventional problem, and an object of the present invention is to provide a surface protective sheet, which satisfactorily adheres to an adherend and which can be easily re-released and suppresses contamination due to a pressure-sensitive adhesive remaining on the surface of the adherend after the release of the sheet.

A surface protective sheet of the present invention includes: a base material layer; and a pressure-sensitive adhesive layer, in which a difference ΔT (%) between the visible light transmittance T₁ (%) of a transparent substrate having an antireflection film and the visible light transmittance T₂ (%) of the transparent substrate resulting when the surface protective sheet is attached to one side of the transparent substrate and left to stand at 160°C for 1 hour, and then the surface protective sheet is released under a temperature environment of 23°C (ΔT=T₁-T₂) satisfies the relationship of ΔT≤1.8.

In a preferred embodiment, a main component in a pressure-sensitive adhesive for constructing the above-mentioned pressure-sensitive adhesive layer includes a polymer P obtained by cross-linking a polymer A.

In a preferred embodiment, the above-mentioned polymer A includes an acrylic polymer obtained by polymerizing a monomer composition containing a (meth)acrylate monomer as a main component.

In a preferred embodiment, the difference ΔT (%) and the elastic modulus in tension E (GPa) of the above-mentioned surface protective sheet satisfy the relationship of ΔT/E^{1/10}≤2.0.

In a preferred embodiment, the surface protective sheet of the present invention is used for protecting a surface of a substrate whose degree of contamination is requested to be low.

In a preferred embodiment, the surface protective sheet of the present invention is used for protecting a substrate having an antireflection film.

In a preferred embodiment, the surface protective sheet of the present invention is used for protecting a surface of a cover glass for a solar cell.

According to the present invention, it is possible to provide the surface protective sheet, which satisfactorily adheres to an adherend and which can be easily re-released and suppresses contamination due to a pressure-sensitive adhesive remaining on the surface of the adherend after the release of the sheet.

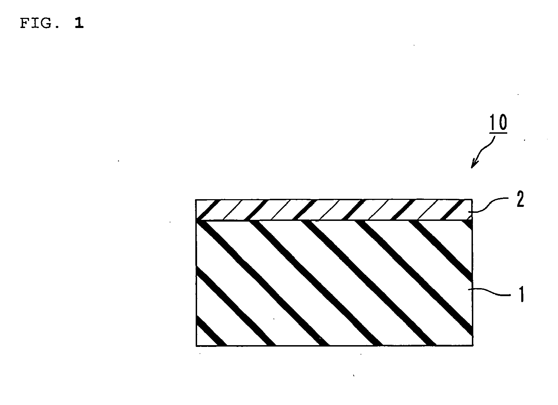

FIG. **1** is a schematic sectional view of a surface protective sheet according to a preferred embodiment of the present invention.

### «A. Surface protective sheet»

A surface protective sheet of the present invention includes a base material layer and a pressure-sensitive adhesive layer. FIG. **1** is a schematic sectional viewof a surfaceprotective sheet according to a preferred embodiment of the present invention. A surface protective sheet **10** includes a base material layer **1** and a pressure-sensitive adhesive layer 2. The surface protective sheet of the present invention may further have any appropriate other layer as required (not shown).

The surface of the base material layer **1** on which the pressure-sensitive adhesive layer **2** is not provided can be subj ected to a release treatment by adding, for example, a fatty acid amide, a polyethyleneimine, or a long-chain alkyl-based additive to the base material layer, or can be provided with a coat layer formed of any appropriate releasing agent such as a silicone-, long-chain alkyl-, or fluorine-based releasing agent for the purpose of, for example, forming a winding body that can be easily rewound. In addition, separately from the base material, a release liner having releasability may be attached.

The thickness of the surface protective sheet of the present invention can be set to any appropriate thickness depending on applications. The thickness is preferably 10 to 300 µm, more preferably 15 to 250 µm, still more preferably 20 to 200 µm, particularly preferably 25 to 150 µm from the viewpoints of, for example, the prevention of a flaw and an adhesion.

The surface protective sheet of the present invention is such that a difference ΔT (%) between the visible light transmittance T₁ (%) of a transparent substrate having an antireflection film and the visible light transmittance T₂ (%) of the transparent substrate resulting when the surface protective sheet is attached to one side of the transparent substrate and left to stand at 160°C for 1 hour, and then the surface protective sheet is released under a temperature environment of 23°C (ΔT=T₁-T₂) satisfies the relationship of ΔT≤1.8. The use of such surface protective sheet can suppress contamination due to the remaining of a pressure-sensitive adhesive even when the sheet is attached to a substrate having an antireflection film. In the surface protective sheet of the present invention, the relationship of ΔT≤1.6 is preferably satisfied, and the relationship of ΔT≤1.4 is more preferably satisfied.

The surface protective sheet of the present invention is preferably such that the elastic modulus in tension E (GPa) of the surface protective sheet and the difference ΔT (%) between the visible light transmittance T₁ (%) of a transparent substrate having an antireflection film and the visible light transmittance T₂ (%) of the transparent substrate resulting when the surface protective sheet is attached to one side of the transparent substrate and left to stand at 160°C for 1 hour, and then the surface protective sheet is released under a temperature environment of 23°C (ΔT=T₁-T₂) satisfy the relationship of ΔT/E^{1/10}≤2.0. The use of such surface protective sheet can additionally suppress contamination due to the remaining of the pressure-sensitive adhesive even when the sheet is attached to a substrate having an antireflection film. In the surface protective sheet of the present invention, the relationship of ΔT/E^{1/10}≤1.7 is preferably satisfied, and the relationship of ΔT/E^{1/10}≤1.5 is more preferably satisfied.

The elastic modulus in tension E (GPa) of the surface protective sheet of the present invention is not particularly limited, but it is preferred that the relationship of ΔT/E^{1/10}≤2.0 be satisfied in the surface protective sheet. The elastic modulus in tension of the surface protective sheet is preferably 0.5 GPa or more, more preferably 0.5 GPa to 5.0 GPa. When the elastic modulus in tension of the surface protective sheet of the present invention falls within the above-mentioned range, a contact area between the pressure-sensitive adhesive layer of the surface protective sheet and an adherend (in particular, an adherend having an antireflection film having extremely fine unevenness) can be decreased to additionally suppress contamination of the adherend due to the remaining of the pressure-sensitive adhesive.

In the surface protective sheet of the present invention, no particular limitation is imposed on the difference ΔT (%) between the visible light transmittance T₁ (%) of a transparent substrate having an antireflection film and the visible light transmittance T₂ (%) of the transparent substrate resulting when the surface protective sheet is attached to one side of the transparent substrate and left to stand at 160°C for 1 hour, and then the surface protective sheet is released under a temperature environment of 23°C (ΔT=T₁-T₂). The relationship of ΔT≤1.8 has only to be satisfied. ΔT (%) satisfies preferably 0≤ΔT≤1.8, more preferably 0≤AT≤1.6, still more preferably 0≤ΔT≤1.4. When ΔT (%) falls within the above-mentioned range, contamination due to the remaining of the pressure-sensitive adhesive can be suppressed to sufficiently maintain the function of the antireflection film.

### <A-1. Base material layer>

Any appropriate thickness can be adopted as the thickness of the base material layer depending on applications. The thickness of the base material layer is preferably 5 to 300 µm, more preferably 10 to 250 µm, still more preferably 15 to 200 µm, particularly preferably 20 to 150 µm.

The base material layer may be a single layer, or may be a laminate of two or more layers. The base material layer may be stretched.

Any appropriate material can be adopted as a material for the base material layer depending on applications. Examples of the material include a plastic, paper, a metal film, and a nonwoven fabric. Of those, a plastic is preferred. The materials may be used alone or in combination to construct the base material layer. For example, the layer may be constructed of two or more kinds of plastics.

Examples of the above-mentioned plastic include a polyester-based resin, a polyamide-based resin, and a polyolefin-based resin. Examples of the polyester-based resin include polyethylene terephthalate, polybutylene terephthalate, and polyethylene naphthalate. Examples of the polyolefin-based resin include a homopolymer of an olefin monomer and a copolymer of olefinmonomers. Specific examples of the polyolefin-based resin include: homopolypropylene; propylene-based copolymers such as block, random, and graft copolymers each including an ethylene component as a copolymer component; reactor TPO; ethylene-based polymers such as low density, high density, linear low density, and ultra low density polymers; and ethylene-based copolymers such as an ethylene-propylene copolymer, an ethylene-vinyl acetate copolymer, an ethylene-methyl acrylate copolymer, an ethylene-ethyl acrylate copolymer, an ethylene-butyl acrylate copolymer, an ethylene-methacrylic acid copolymer, and an ethylene-methyl methacrylate copolymer.

The base material layer may contain any appropriate additive as required. Examples of the additive that canbe contained in the base material layer include an antioxidant, a UV absorbing agent, a light stabilizer, an antistatic agent, a filler, and a pigment. The kind, number, and amount of the additive that can be contained in the base material layer can be appropriately set depending on purposes. In particular, when the material for the base material layer is a plastic, it is preferred to contain some of the above-mentioned additives for the purpose of, for example, preventing deterioration. From the viewpoint of, for example, the improvement of weather resistance, particularly preferred examples of the additive include an antioxidant, a UV absorbing agent, a light stabilizer, and a filler.

Any appropriate antioxidant can be adopted as the antioxidant. Examples of such antioxidant include a phenol-based antioxidant, a phosphorus-based processing heat stabilizer, a lactone-based processing heat stabilizer, a sulfur-based heat stabilizer, andaphenol-phosphorus-basedantioxidant. The content of the antioxidant is preferably 1 part by weight or less, more preferably 0.5 part by weight or less, still more preferably 0.01 to 0.2 part by weight with respect to 100 parts by weight of the base resin of the base material layer (when the base material layer is a blend, the blend is the base resin).

Any UV absorbing agent can be adopted as the UV absorbing agent. Examples of such UV absorbing agent include a benzotriazole-based UV absorbing agent, a triazine-based UV absorbing agent, and a benzophenone-based UV absorbing agent. The content of the UV absorbing agent is preferably 2 parts by weight or less, more preferably 1 part by weight or less, still more preferably 0.01 to 0.5 part by weight with respect to 100 parts by weight of the base resin that forms the base material layer (when the base material layer is a blend, the blend is the base resin).

Any appropriate light stabilizer can be adopted as the light stabilizer. Examples of such light stabilizer include a hindered amine-based light stabilizer and a benzoate-based light stabilizer. The content of the light stabilizer is preferably 2 parts by weight or less, more preferably 1 part by weight or less, still more preferably 0.01 to 0.5 part by weight with respect to 100 parts by weight of the base resin that forms the base material layer (when the base material layer is a blend, the blend is the base resin).

Any appropriate filler can be adopted as the filler. Examples of such filler include an inorganic filler. Specific examples of the inorganic filler include carbon black, titanium oxide, and zinc oxide. The content of the filler is preferably 20 parts by weight or less, more preferably 10 parts by weight or less, still more preferably 0.01 to 10 parts by weight with respect to 100 parts by weight of the base resin that forms the base material layer (when the base material layer is a blend, the blend is the base resin).

Further, a surfactant, an inorganic salt, a polyhydric alcohol, a metal compound, an inorganic antistatic agent such as carbon, and low molecular-weight and high molecular-weight antistatic agents each intended to impart antistatic property are also preferably given as examples of the additive. Of those, a high-molecular weight antistatic agent or carbon is particularly preferred from the viewpoints of contamination and the maintenance of pressure-sensitive adhesiveness.

### <A-2. Pressure-sensitive adhesive layer>

The thickness of the pressure-sensitive adhesive layer is preferably 0.1 to 100 µm, more preferably 0.5 to 50 µm, still more preferably 1.0 to 30 µm, particularly preferably 1 to 20 µm.

The pressure-sensitive adhesive layer is constructed ofapressure-sensitiveadhesive. Thepressure-sensitiveadhesives maybe used alone or in combination. Thepressure-sensitive adhesive preferably contains a polymer P obtained by cross-linking a polymer A as a main component. Specifically, the content of the polymer P in the pressure-sensitive adhesive is preferably 50 wt% or more, more preferably 80 wt% or more, still more preferably 90 wt% or more, particularly preferably 95 wt% or more.

The polymer A has a weight-average molecular weight Mw (in terms of a standard polystyrene) of preferably 500,000 or more, more preferably 520, 000 to 2, 000, 000, still more preferably 550, 000 to 1,500,000. As long as the weight-average molecular weight Mw of the polymer A falls within the above-mentioned range, a surface protective sheet which suppresses contamination of the adherend due to the remaining of the pressure-sensitive adhesive can be provided.

The polymer A has a distribution degree Mw/Mn of preferably 8.0 or less, more preferably 2.0 to 7.0, still more preferably 3.0 to 5.0. As long as the molecular weight distribution Mw/Mn of the polymer A falls within the above-mentioned range, a surface protective sheet which suppresses contamination of the adherend due to the remaining of the pressure-sensitive adhesive can be provided.

The insoluble content of the polymer P in ethyl acetate is preferably 90 wt% or more, more preferably 95 wt% or more, still more preferably 97 wt% or more. As long as the insoluble content of the polymer P in ethyl acetate falls within the above-mentioned range, a surface protective sheet which suppresses contamination of the adherend due to the remaining of the pressure-sensitive adhesive can be provided.

In the surfaceprotective sheet of the present invention, it is particularly preferred that the weight-average molecular weight Mw of the polymer A be 500,000 or more, the distribution degree Mw/Mn of the polymer A be 8.0 or less, and the insoluble content of the polymer P in ethyl acetate be 90 wt% or more for the purpose of providing a surface protective sheet that does not impair the self-cleaning property of the surface of a coated plate and the reflectance of a substrate having an antiref lection function.

An area ratio of a weight-average molecular weight Mw of 2,500 or less in the GPC measurement of the soluble components of the polymer P in ethyl acetate is preferably 50% or more, more preferably 60% or more, still more preferably 70% or more. A soluble component having a weight-average molecular weight Mw in excess of 2,500 in the GPC measurement of the soluble components of the polymer P in ethyl acetate causes contamination due to the pressure-sensitive adhesive remaining on the surface of an adherend. For example, when the sheet is attached to a substrate having an antireflection film, such component may impair the characteristics of the antireflection film.

Any appropriate pressure-sensitive adhesive can be adopted as the pressure-sensitive adhesive for constructing the pressure-sensitive adhesive layer. Examples of such pressure-sensitive adhesive include an acrylic pressure-sensitive adhesive, a silicone-based pressure-sensitive adhesive, and a rubber-based pressure-sensitive adhesive. Of those, an acrylic pressure-sensitive adhesive is particularly preferred as the pressure-sensitive adhesive.

The polymer A before the cross-linking for obtaining the polymer P as a main component in the acrylic pressure-sensitive adhesive is preferably an acrylic polymer obtained by polymerizing a monomer composition containing a (meth)acrylate monomer as a main component. The adoption of such acrylic polymer as the polymer A can provide a surface protective sheet which suppresses contamination of the adherend due to the remaining of the pressure-sensitive adhesive. It shouldbe noted that the expression "(meth)acrylate" means at least one of an acrylate and a methacrylate.

The content of the (meth) acrylate monomer in the monomer composition is preferably 50 wt% or more, more preferably 60 to 99 wt%, still more preferably 70 to 98 wt%, particularly preferably 80 to 97 wt%. When the content of the (meth)acrylate monomer in the monomer composition falls within the above-mentioned range, a surface protective sheet which satisfactorily adheres to an adherend and which can be easily re-released and suppresses contamination due to the pressure-sensitive adhesive remaining on the surface of the adherend after the release of the sheet can be provided.

Examples of the (meth)acrylate monomer include methyl (meth)acrylate, ethyl (meth)acrylate, n-butyl (meth)acrylate, s-butyl (meth)acrylate, t-butyl (meth)acrylate, isobutyl (meth)acrylate, hexyl (meth)acrylate, 2-ethylhexyl (meth)acrylate, n-octyl (meth)acrylate, isooctyl (meth)acrylate, n-nonyl (meth)acrylate, isononyl (meth)acrylate, n-decyl (meth)acrylate, isodecyl (meth)acrylate, n-dodecyl (meth)acrylate, n-tridecyl (meth)acrylate, and n-tetradecyl (meth)acrylate.

The (meth)acrylate monomers may be used alone or in combination in the monomer composition.

It is preferred that the monomer composition include a functional group-containing monomer for cross-linking. Examples of such functional group-containing monomer include a carboxyl group-containing monomer, an acid anhydride group-containing monomer, a hydroxyl group-containing monomer, an amino group-containing monomer, an epoxy group-containing monomer, an isocyanate group-containing monomer, and an aziridine group-containing monomer. Specific examples of such functional group-containing monomer include (meth)acrylic acid, 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate, (4-hydroxymethylcyclohexyl)methyl acrylate, N-methylol (meth)acrylamide, vinyl alcohol, allyl alcohol, 2-hydroxyethyl vinyl ether, 4-hydroxybutyl vinyl ether, diethylene glycol monovinyl ether, glycidyl (meth)acrylate, methylglycidyl (meth)acrylate, and allyl glycidyl ether. It should be noted that the expression "(meth)acrylic acid" means at least one of acrylic acid and methacrylic acid, and the expression "(meth)acrylate" means at least one of an acrylate and a methacrylate.

The functional group-containing monomers may be used alone or in combination in the monomer composition.

The content of the functional group-containing monomer in the monomer composition is preferably 1 to 25 wt%, more preferably 1 to 20 wt%, still more preferably 2 to 15 wt%, particularlypreferably 3 to 10 wt%. When the content of the functional group-containing monomer in the monomer composition falls within the above-mentioned range, a surface protective sheet which satisfactorily adheres to an adherend and which can be easily re-released and suppresses contamination due to a pressure-sensitive adhesive remaining on the surface of the adherend after the release of the sheet can be provided.

The monomer composition may include, as a monomer for controlling releasability,a sulfonic acid group-containing monomer, a phosphoric acid group-containing monomer,a cyano group-containing monomer, a vinyl ester monomer, an aromatic vinyl monomer, an amide group-containing monomer, an imide group-containing monomer, N-acryloylmorpholine, a vinyl ether monomer, or the like. Specific examples of such monomer include styrene, chlorostyrene, chloromethylstyrene, α-methylstyrene, vinyl acetate, and acrylonitrile. The above-mentioned monomers in the monomer composition may be used alone or in combination.

The acrylic pressure-sensitive adhesive capable of constructing the pressure-sensitive adhesive layer has a glass transition temperature (Tg) in the FOX equation of preferably -80 to 0°C, more preferably -70 to -10°C, still more preferably -60 to -20°C. As long as the glass transition temperature (Tg) falls within the above-mentioned range, a surface protective sheet which suppresses contamination of the adherend due to the remaining of the pressure-sensitive adhesive can be provided. It should be noted that the glass transition temperature (Tg) can be adjusted by appropriately changing monomer components to be used and their composition ratio.

The polymer P is obtained by cross-linking the polymer A. That is, examples of the polymer P include a cross-linked polymer obtained by causing the polymer A and any appropriate cross-linking agent to react with each other, and a cross-linked polymer obtained by irradiating the polymer A with an active energy ray (such as ultraviolet light or an electron beam) to subject the polymer to a cross-linking reaction.

Any appropriate cross-linking agent can be adopted as a cross-linking agent that can be used for cross-linking the polymer A to provide the polymer P. Examples of such cross-linking agent include an epoxy-based cross-linking agent, a polyfunctional isocyanate-based cross-linking agent, a melamine resin-based cross-linking agent, a metalsalt-based cross-linking agent, a metal chelate-based cross-linking agent, an amino resin-based cross-linking agent, and a peroxide-based cross-linking agent. It should be noted that a cross-linked structure can be constructed by the application of an active energy ray such as ultraviolet light or an electron beam as well irrespective of whether the cross-linking agent is used. The cross-linking agents may be used alone or in combination.

The usage of the cross-linking agent is preferably 20 parts by weight or less, more preferably 10 parts by weight or less, still more preferably 2 to 10 parts by weight with respect to 100 parts by weight of thepolymerAbefore the cross-linking for obtaining the polymer P as the main component of the pressure-sensitive adhesive. When the content of the cross-linking agent deviates from the above-mentioned range, the cross-linking agent itself and the insoluble content in the pressure-sensitive adhesive may be responsible for contamination.

Examples of the cross-linking agent to be particularly preferably used include an epoxy-based cross-linking agent and a polyfunctional isocyanate-based cross-linking agent.

A polyfunctional epoxy compound is preferably used as the epoxy-based cross-linking agent, and includes various compounds each having two or more epoxy groups in the molecule. Representative examples thereof include sorbitol tetraglycidyl ether, trimethylolpropane glycidyl ether, tetraglycidyl-1,3-bisaminomethylcyclohexane, tetraglycidyl-m-xylenediamine, and triglycidyl-p-aminophenol. The number of parts of the epoxy-based cross-linking agent to be blended varies depending on the amount of an acid to be introduced into a pressure-sensitive adhesive polymer and the structure of the epoxy-based cross-linking agent, but is generally preferably 1 to 20 parts by weight, more preferably 2 to 10 parts by weight with respect to 100 parts by weight of the polymer A before the cross-linking for obtaining the polymer P.

A polyfunctional isocyanate compound is preferably used as the isocyanate-based cross-linking agent, and includes various compounds each including two or more isocyanate groups in the molecule. Representative examples thereof include diphenylmethane diisocyanate, tolylene diisocyanate, and hexamethylene diisocyanate. The number of parts of the isocyanate-based cross-linking agent to be blended has only to be determined so as not to affect pressure-sensitive adhesive property, and is generally preferably 0.5 to 10 parts by weight, more preferably 1 to 5 parts by weight with respect to 100 parts by weight of the polymer A before the cross-linking for obtaining the polymer P.

Any appropriate additive can be contained in the pressure-sensitive adhesive for constructing the pressure-sensitive adhesive layer. Examples of such additive include a softener, a tackifier, a surface lubricating agent, a leveling agent, an antioxidant, a corrosion inhibitor, a light stabilizer, a UV absorbing agent, aheatstabilizer, a polymerization inhibitor, a silane coupling agent, a lubricant, an inorganic or organic filler, a metal powder, a pigment, and a solvent.

The tackifier is effective in improving an adhesion, in particular, improving pressure-sensitive adhesiveness for an adherend having a rough surface. Any appropriate tackifier can be adopted as the tackifier. Examples of such tackifier include petroleum-based resins such as an aliphatic copolymer, an aromatic copolymer, an aliphatic-aromatic copolymer system, and an alicyclic copolymer, a coumarone-indene-based resin, a terpene-based resin, a terpene phenol-based resin, a rosin-based resin such as a polymerized rosin, an (alkyl) phenol-based resin, a xylene-based resin, and hydrogenated products thereof. The tackifiers may be used alone or in combination.

The content of the tackifier is preferably 50 parts by weight or less, more preferably 30 parts by weight or less, still more preferably 10 parts by weight or less with respect to 100 parts by weight of the polymer P as the main component of the pressure-sensitive adhesive. When the content of the tackifier deviates from the above-mentioned range, pressure-sensitive adhesiveness at low temperatures may be poor or an adhesive residue at high temperatures may be remarkable.

The pressure-sensitive adhesive for constructing the pressure-sensitive adhesive layer can be produced by any appropriate method. The pressure-sensitive adhesive for constructing the pressure-sensitive adhesive layer can be produced, for example, as described below. While a polymerization method to be generally employed as an approach to synthesizing a polymer, such as solution polymerization, emulsion polymerization, bulk polymerization, suspension polymerization,or polymerization with ultraviolet light (UV) is employed, any appropriate cross-linking method is adopted, and any appropriate additive is used as required.

Of the polymerization methods, solution polymerization, emulsion polymerization, suspension polymerization, or polymerization with ultraviolet light (UV) is preferred because a pressure-sensitive adhesive having a high molecular weight and a low distribution degree can be produced. With regard to, for example, the solution polymerization, a polymerization initiator and a solvent are added to the monomer composition, and any appropriate additive is added to the mixture as required so that the solution polymerization may be performed.

Any appropriate polymerization initiator can be adopted as the polymerization initiator. Examples of such polymerization initiator include an azo-based compound and a peroxide. Specific examples of such polymerization initiator include 2,2'-azobisisobutyronitrile, 2,2'-azobisisovaleronitrile, 2,2'-azobis(4-methoxy-2,4-dimethylvaleronitrile), 2,2'-azobis(2,4-dimethylvaleronitrile), 2,2'-azobis(2-methylbutyronitrile), 1,1'-azobis(cyclohexane-1-carbonitrile), 2,2'-azobis(2,4,4-trimethylpentane), dimethyl-2,2'-azobis(2-methylpropionate), benzoyl peroxide, t-butyl hydroperoxide, di-t-butyl hydroperoxide, t-butyl peroxybenzoate, dicumyl peroxide, 1,1-bis(t-butylperoxy)-3,3,5-trimethylcyclohexane, and 1,1-bis(t-butylperoxy)cyclododecane.

### «B. Method of producing surface protective sheet»

The surface protective sheet of the present invention can be produced by any appropriate method. The production can be performed in conformity with, as suchproductionmethod, any appropriate method of producing a pressure-sensitive adhesive sheet, such as:
(1) a method involving applying a solution of the pressure-sensitive adhesive in a solvent or a hot-melt liquid thereof to the base material;
(2) a method involving transferring the pressure-sensitive adhesive layer applied and formed in a separator fashion in conformity with the foregoing;
(3) a method involving extruding a material for forming the pressure-sensitive adhesive layer onto the base material to form and apply the layer;
(4) a method involving extruding the base material and the pressure-sensitive adhesive layer in two layers or a plurality of layers;
(5) a method involving laminating a single layer of the pressure-sensitive adhesive layer onto the base material or a method involving laminating two layers of a laminate layer and the pressure-sensitive adhesive layer; or
(6) a method involving laminating two layers, or a plurality of layers, of the pressure-sensitive adhesive layer and a material for forming the base material such as a film or a laminate layer.

Examples of the above-mentioned application method include methods each involving the use of a bar coater, a gravure coater, a spin coater, a roll coater, a knife coater, or an applicator.

The method involving applying a solution of the pressure-sensitive adhesive in a solvent or a hot-melt liquid thereof to the base material is particularly preferred as the method of producing the surface protective sheet of the present invention in terms of productivity and a cost.

### «C. Applications of surface protective sheet»

The surface protective sheet of the present invention satisfactorily adheres to an adherend and can be easily re-released and suppress contamination due to a pressure-sensitive adhesive remaining on the surface of the adherend after the release of the sheet. Accordingly, the surface protective sheet of the present invention can be used in any appropriate application. The surface protective sheet can be preferably used in, for example, an application where the surface of a member such as a metal plate, a coated plate, an aluminum sash, a resin plate, a decorated steel plate, a vinyl chloride-laminated steel plate, or a glass plate, an optical member such as a polarizing sheet or a liquid crystal panel, an electronic member, or the like is protected by attaching the sheet to the surface of any such member during, for example, conveyance, processing, or guarding of the member. The surface protective sheet is particularly useful as a surface protective sheet, whose degree of contamination is requested to be low, for a hydrophilic member obtained by hydrophilizing the surface of a metal plate, a resin plate, a glass plate, or the like with a hydrophilic coating film or a surface treatment, a substrate with an antireflection function formed so as to have a thickness corresponding to a quarter of a wavelength to be prevented from reflecting, a substrate with an antireflection function based on a nano-level uneven structure, or the like. More specifically, the surface protective sheet of the present invention can be suitably used in an application such as the protection of the surface of a hydrophilic coated plate, the protection of the surface of a substrate whose degree of contamination is requested to be low, the protection of a substrate having an antireflection film, or the protection of the surface of a cover glass for a solar cell.

Hereinafter, the present invention is described specifically by way of examples. However, the present invention is by no means limited to these examples. It should be noted that test and evaluation methods in the examples and the like are as described below. In addition, the term "part(s)" means "part(s) by weight."

### (Elastic modulus in tension)

Measurement was performed in conformity with JIS K7161 under the following conditions. An elastic modulus in tension was determined by the linear regression of a curve between two specified strains ε₁=1 and ε₂=2. The measurement was performed at 25°C using a test piece measuring 10 mm in width with an Instron tensile tester (AUTOGRAPH manufactured by Shimadzu Corporation) under the conditions of a tension speed of 0.3 m/min and a chuck-to-chuck distance of 50 mm. The measurement was performed using a product obtained by releasing the polyethylene film from the surface protective sheet obtained in each of Examples and Comparative Examples. Further, a measured value was determined in terms of a value per sectional area of the base material on the basis of a thickness value obtained by subtracting the thickness of the pressure-sensitive adhesive from the actual value for the thickness of the surface protective sheet. It should be noted that elastic moduli were measured in two directions perpendicular to each other, and the larger of the resultant values was adopted as the elastic modulus in tension of the surface protective sheet.

### (Visible light transmittance)

The visible light transmittance at 380 to 780 nm of a glass having an antireflection film was measured with a spectrophotometer (manufacturedbyHitachi, Ltd., model: U-4100) to determine a visible light transmittance T₁ (%). It should be noted that the visible light transmittance was measured in conformity with a test method for the transmittance of a plate glass specified in JIS R3106-1998 (visible light transmittance).
Next, to one side of the glass was attached the surface protective sheet obtained in Example or Comparative Example, and the resultant was left to stand at 160°C for 1 hour and then left to stand at 23°C for 30 minutes to return to room temperature. After that, the surface protective sheet was released at 23°C and the resultant glass was measured for its visible light transmittance in the same manner as above to determine a visible light transmittance T₂%. The resultant visible light transmittance values were used to calculate a difference ΔT (%) (ΔT=T₁-T₂) in visible light transmittance.

### (Weight-average molecular weight Mw and distribution degree Mw/Mn)

A weight-average molecular weight Mw and a distribution degree Mw/Mn were measured by a gel permeation chromatography method (GPC method) with an HLC-8120 (manufactured by TOSOH CORPORATION) as described below. The measurement was performed by using columns each having an inner diameter of 6.0 mm and a length of 150 mm (TSKgel SuperHZM-H/HZ4000/HZ3000/HZ2000 manufactured by TOSOH CORPORATION), the columns being connected in series, and tetrahydrofuran as an eluent under the conditions of a concentration of 1 g/L, a flow rate of 0.6 ml/min, a temperature of 40°C, and a sample injection amount of 20 µl. An RI detector was used as a detector. In addition, a TSK standard polystyrene (manufactured by TOSOH CORPORATION) was used for creating a molecular weight calibration curve.

### (Contamination resistance)

To a glass having an antireflection film was attached the surface protective sheet of Example or Comparative Example, and the resultant was left to stand at 160°C for 1 hour and then left to stand at 23°C for 30 minutes to return to room temperature. After that, the surface protective sheet was released at 23°C, and the presence or absence of contamination due to the pressure-sensitive adhesive remaining on the glass was observed with eyes.
○: No contamination due to the pressure-sensitive adhesive remaining on the glass is observed after the release of the surface protective sheet.
×: Contamination due to the pressure-sensitive adhesive remaining on the glass is observed after the release of the surface protective sheet.

### (Production Example 1): Production of base material 1

80 parts of polypropylene (PP) (40 parts of crystalline homopolypropylene (HPP) having a resin density of 0.905 and 40 parts of random polypropylene (RPP) having a resin density of 0.900), 10 parts of polyethylene (PE) (trade name "Petrocene 205" manufactured by TOSOH CORPORATION), and 10 parts of an ethylene-propylene copolymer (EPR) ("Tafmer P0180" manufactured by Mitsui Chemicals, Inc.) were formed into a film by a T-die method so that a die temperature was 160°C. Thus, a base material 1 having a thickness of 35 um was obtained.

### (Production Example 2): Production of base material 2

100 parts of a polyethylene resin (Petrocene 183 manufactured by TOSOH CORPORATION) was formed into a film by an inflation method so that a die temperature was 160°C. Thus, a base material 2 having a thickness of 60 µm was obtained.

### (Production Example 3): Production of base material 3

Acommerciallyavailablepolyester film (Lumirror (registered trademark) S-10 manufactured by Toray Industries, Inc., thickness: 38 µm) was used as a base material 3.

### (Production Example 4): Production of base material 4

Acommerciallyavailablepolyester film (Lumirror (registered trademark) S-10 manufactured by Toray Industries, Inc., thickness: 25 µm) was used as a base material 4.

### (Production Example 5): Production of polymer A(1)

A mixed solution of 95 parts of butyl acrylate and 5 parts of acrylic acid, 0.40 part of 2,2'-azobisisobutyronitrile as a polymerization initiator, and 300 parts of ethyl acetate were loaded into a reaction vessel provided with a cooling tube, a nitrogen-introducing tube, a temperature gauge, and a stirring apparatus, and then the mixture was subjected to polymerization at 60°C for 12 hours. Thus, a solution of a polymer A(1) was obtained. The resultant polymer A(1) had a weight-average molecular weight Mw of 600,000 and a molecular weight distribution Mw/Mn of 4.0.

### (Production Example 6): Production of polymer A(2)

A solution of a polymer A(2) was obtained in the same manner as in Production Example 5 except that a mixed solution of 97 parts of butyl acrylate and 3 parts of acrylic acid, 0.20 part of 2,2'-azobisisobutyronitrile as a polymerization initiator, and 200 parts of ethyl acetate were used. The resultant polymer A(2) had a weight-average molecular weight Mw of 1, 000, 000 and a molecular weight distribution Mw/Mn of 3.9.

### (Production Example 7): Production of polymer A(3)

A mixed solution of 70 parts of butyl acrylate, 30 parts of ethyl acrylate, 5 parts of acrylic acid, and 1 part of hydroxyethyl acrylate, 0.2 part of azobisisobutyronitrile as a polymerization initiator, and 250 parts of ethyl acetate were loaded into a reaction vessel provided with a cooling tube, a nitrogen-introducing tube, a temperature gauge, and a stirring apparatus, and then the mixture was subj ected to polymerization at 60°C for 6 hours. Thus, a solution of a polymer A(3) was obtained. The resultant polymer A(3) had a weight-average molecular weight Mw of 1,400,000 and a molecular weight distribution Mw/Mn of 4.9.

### (Production Example 8): Production of glass substrate (1) having antireflection film

### (Production of coating material composition for forming antireflection film)

To a 200-mL vessel made of glass were loaded 60 g of ethanol, 30 g of a water dispersion sol of ZnO fine particles (average primary particle diameter: 20 nm, average aggregate particle diameter: 40 nm, concentration in terms of solid content: 20% by mass), and 10 g of tetraethoxysilane (SiO₂ solid content: 29% by mass), and an aqueous ammonia solution was added to the mixture to achieve a pH of 10. The resultant mixture was stirred at 20°C for 6 hours to provide 100 g of a dispersion of core-shell particles (solid content: 6% by mass). To 100 g of the resultant dispersion of core-shell particles were added 100 g of a strongly acidic cation exchange resin (total exchange capacity: 2.0 meq/mL or more), and the mixture was stirred for 1 hour to achieve a pH of 4. After that, the strongly acidic cation exchange resin was removed by filtration to provide a dispersion of spherical hollow fine particles each formed of SiO₂. The dispersion was concentrated by ultrafiltration so as to have a solid content of 20% by mass. The spherical hollow fine particles were in the form of secondary aggregates. The outer shell of each of the spherical hollow fine particles had a thickness of 5 nm, which was one sixth of the average primary particle diameter. The spherical hollow fine particles each had an average aggregate particle diameter of 40 nm and an aspect ratio of 1.0.

To a 200-mL vessel made of glass were loaded 2 g of the dispersion of the spherical hollow fine particles (solid content: 20% by mass), 2 g of a dispersion of fibrous solid fine particles (IPA-ST-UP manufactured by Nissan Chemical Industries, Ltd., average aggregate particle diameter (average primary particle diameter): 90nm, aspect ratio: 7.0, solid content: 15% by mass), 90 g of ethanol, and 6 g of a silicic acid oligomer solution (solid content: 5% by mass), and the mixture was stirred for 10 minutes to provide a coating material composition for forming an antireflection film.

### (Formation of antireflection film on glass substrate)

The above-mentioned coating material composition was applied to both surfaces of a glass substrate (100 mm×100 mm, thickness: 3.5 mm) wiped with ethanol, made uniform by spin coating at a number of revolutions of 200 rpm for 60 seconds, and then dried at 200°C for 30 minutes to form an antireflection film having a thickness of 100 nm. Thus, a glass substrate (1) having an antireflection film was obtained.

### (Production Example 9): Production of glass substrate (2) having antireflection film

A solution having dispersed therein glass particles eachhaving a refractive index different from that of a glass substrate was applied to the glass substrate so as to have a thickness after drying of about 100 nm, and then dried at 200 to 250°C for 1 hour to provide a glass substrate (2) having an antireflection film having a visible light transmittance of 92 to 95%.

### (Example 1)

A mixed solution prepared by adding 8. 0 parts of an epoxy-based cross-linking agent (TETRAD C manufactured by Mitsubishi Gas Chemical Company, Inc.) to 100 parts of the solid content of the polymer A(1) was applied to the base material 1 one surface of which had been subjected to a corona treatment so that the thickness of a pressure-sensitive adhesive layer after drying was 5 µm. Thus, a surface protective sheet was produced. In addition, conditions at the time of the drying were 85°C and 5 minutes. The resultant surface protective sheet was attached to a polyethylene film, and then the resultant was left to stand at 50°C for 3 days. Table 1 shows the results of the evaluations of the surface protective sheet (1) thus obtained provided with the pressure-sensitive adhesive layer (1) constructed of a pressure-sensitive adhesive containing a polymer P(1) obtained by cross-linking the polymer A(1) as a main component.

### (Example 2)

A mixed solution prepared by adding 6.0 parts of an epoxy-based cross-linking agent (TETRAD C manufactured by Mitsubishi Gas Chemical Company, Inc.) to 100 parts of the solid content of the polymer A(1) was applied to the base material 3 one surface of which had been subjected to a corona treatment so that the thickness of a pressure-sensitive adhesive layer after drying was 5 µm. Thus, a surface protective sheet was produced. In addition, conditions at the time of the drying were 85°C and 5 minutes. The resultant surface protective sheet was attached to a silicone-treated surface of a polyethylene film one surface of which had been subjected to a silicone treatment, and then the resultant was left to stand at 50°C for 3 days. Table 1 shows the results of the evaluations of the surface protective sheet (2) thus obtained provided with the pressure-sensitive adhesive layer (2) constructed of a pressure-sensitive adhesive containing a polymer P(2) obtained by cross-linking the polymer A(1) as a main component.

### (Example 3)

A surface protective sheet was produced in the same manner as in Example 2 except that a mixed solution prepared by adding 6.0 parts of an epoxy-based cross-linking agent (TETRAD C manufactured by Mitsubishi Gas Chemical Company, Inc.) to 100 parts of the solid content of the polymer A(2) was used. Table 1 shows the results of the evaluations of the surface protective sheet (3) thus obtained provided with a pressure-sensitive adhesive layer (3) constructed of a pressure-sensitive adhesive containing a polymer P(3) obtained by cross-linking the polymer A(2) as a main component.

### (Example 4)

A surface protective sheet was produced in the same manner as in Example 2 except that a mixed solution prepared by adding 3.0 parts of an epoxy-based cross-linking agent (TETRAD C manufactured by Mitsubishi Gas Chemical Company, Inc.) to 100 parts of the solid content of the polymer A(2) was used. Table 1 shows the results of the evaluations of the surface protective sheet (4) thus obtained provided with a pressure-sensitive adhesive layer (4) constructed of a pressure-sensitive adhesive containing a polymer P(4) obtained by cross-linking the polymer A(2) as a main component.

### (Example 5)

A surface protective sheet was produced in the same manner as in Example 2 except that a mixed solution prepared by adding 8.0 parts of an epoxy-based cross-linking agent (TETRAD C manufactured by Mitsubishi Gas Chemical Company, Inc.) to 100 parts of the solid content of the polymer A(1) was applied to the base material 4 one surface of which had been subjected to a corona treatment so that the thickness of a pressure-sensitive adhesive layer after drying was 3 µm. Table 1 shows the results of the evaluations of the surface protective sheet (5) thus obtained provided with the pressure-sensitive adhesive layer (5) constructed of a pressure-sensitive adhesive containing a polymer P(1) obtained by cross-liking the polymer A(1) as a main component.

### (Example 6)

A surface protective sheet was produced in the same manner as in Example 2 except that a mixed solution prepared by adding 11.0 parts of an epoxy-based cross-linking agent (TETRAD C manufactured by Mitsubishi Gas Chemical Company, Inc.) and 10.0 parts of an isocyanate-based cross-linking agent (Coronate L manufactured by Nippon Polyurethane Industry Co., Ltd.) to 100 parts of the solid content of the polymer A(3) was used. Table 1 shows the results of the evaluations of the surface protective sheet (6) thus obtained provided with a pressure-sensitive adhesive layer (6) constructed of a pressure-sensitive adhesive containing a polymer P(6) obtained by cross-linking the polymer A(3) as a main component.

### (Comparative Example 1)

A surface protective sheet was produced in the same manner as in Example 3 except that the base material 2 was used as the base material. Table 1 shows the results of the evaluations of the surface protective sheet (C1) thus obtained provided with a pressure-sensitive adhesive layer (C1) constructed of a pressure-sensitive adhesive containing a polymer P(C1) obtained by cross-linking the polymer A(1) as a main component.

### (Comparative Example 2)

A surface protective sheet was produced in the same manner as in Example 2 except that a mixed solution prepared by adding 1.0 part of an epoxy-based cross-linking agent (TETRAD C manufactured by Mitsubishi Gas Chemical Company, Inc.) to 100 parts of the solid content of the polymer A(1) was used. Table 1 shows the results of the evaluations of the surface protective sheet (C2) thus obtained provided with a pressure-sensitive adhesive layer (C2) constructed of a pressure-sensitive adhesive containing a polymer P(C2) obtained by cross-linking the polymer A(1) as a main component.

**[Table 1]**

| | ΔT (%) | | Elastic modulus E (GPa) | ΔT/E^{1/10} | | Contamination resistance | |
|---|---|---|---|---|---|---|---|
| | Glass substrate | Glass substrate | | Glass substrate | Glass substrate | Glass substrate | Glass substrate |
| | (1) | (2) | | (1) | (2) | (1) | (2) |
| Example 1 | 1.36 | - | 0.64 | 1.4 | - | o | - |
| Example 2 | 0.55 | - | 4.0 | 0.5 | - | o | - |
| Example 3 | 0.81 | - | 4.0 | 0.7 | - | o | - |
| Example 4 | 1.00 | - | 4.0 | 0.9 | - | o | - |
| Example 5 | 0.20 | 0.19 | 4.0 | 0.2 | 0.2 | o | o |
| Example 6 | 0.20 | - | 4.0 | 0.2 | - | o | - |
| Comparative Example 1 | 2.35 | 2.33 | 0.23 | 2.7 | 2.7 | × | × |
| Comparative Example 2 | 2.43 | - | 4.0 | 2.1 | - | × | - |

As is apparent from Table 1, the surfaceprotective sheet of the present invention satisfactorily adheres to an adherend and can be easily re-released and suppresses contamination due to a pressure-sensitive adhesive remaining on the surface of the adherend after the release of the sheet.

The surface protective sheet of the present invention is used in, for example, an application where the surface of a member such as a metal plate, a coated plate, an aluminum sash, a resin plate, a decorated steel plate, a vinyl chloride-laminated steel plate, or a glass plate, an optical member such as a polarizing sheet or a liquid crystal panel, an electronic member, or the like is protected by attaching the sheet to the surface of any such member during, for example, conveyance, processing, or guarding of the member. The surface protective sheet is particularly useful as a surface protective sheet for a hydrophilic member such as a hydrophilic coated plate, a substrate with an antireflection function formed so as to have a thickness corresponding to a quarter of a wavelength to be prevented from reflecting, a substrate with an antireflection function based on a nano-level uneven structure, or the like.

## Claims

1. A surface protective sheet, comprising:
a base material layer; and
a pressure-sensitive adhesive layer,
wherein a difference ΔT (%) between a visible light transmittance T₁ (%) of a transparent substrate having an antireflection film and a visible light transmittance T₂ (%) of the transparent substrate resulting when the surface protective sheet is attached to one side of the transparent substrate and left to stand at 160°C for 1 hour, and then the surface protective sheet is released under a temperature environment of 23°C (ΔT=T₁-T₂) satisfies a relationship of ΔT≤1.8.

2. A surface protective sheet according to claim 1, wherein a main component in a pressure-sensitive adhesive for constructing the pressure-sensitive adhesive layer comprises a polymer P obtained by cross-linking a polymer A.

3. A surface protective sheet according to claim 2, wherein the polymer A comprises an acrylic polymer obtained by polymerizing a monomer composition containing a (meth) acrylate monomer as a main component.

4. A surface protective sheet according to any one of claims 1 to 3, wherein the difference ΔT (%) and an elastic modulus in tension E (GPa) of the surface protective sheet satisfy a relationship of ΔT/E^{1/10}≤2.0.

5. A surface protective sheet according to any one of claims 1 to 4, wherein the sheet is used for protecting a surface of a substrate whose degree of contamination is requested to be low.

6. A surface protective sheet according to any one of claims 1 to 4, wherein the sheet is used for protecting a surface of a substrate having an antireflection film.

7. A surface protective sheet according to any one of claims 1 to 4, wherein the sheet is used for protecting a surface of a cover glass for a solar cell.
